# EUROPÄISCHE PATENTSCHRIFT

(11) **EP 0 940 917 B1**
(45) Veröffentlichungstag und Bekanntmachung des Hinweises auf die Patenterteilung: **08.12.2004**
(21) Anmeldenummer: 99108961.6
(22) Anmeldetag: 13.09.1994
(51) Int. Cl.: H03K 5/08, F04B 49/10, F04C 29/10, H02P 6/14

(54) **Schaltung zur Steuerung mit mehreren Sensoren**
Driving circuit with several sensors
Circuit de commande à capteurs multiples

(30) Priorität: 20.09.1993 DE 4331742; 30.09.1993 DE 4333465; 11.10.1993 DE 4334480; 24.11.1993 DE 4330086
(43) Veröffentlichungstag der Anmeldung: 08.09.1999
(62) Teilanmeldung aus: 94926935.1
(73) Patentinhaber: DEUTSCHE THOMSON-BRANDT GMBH, 78048 Villingen-Schwenningen (DE)
(72) Erfinder: Gleim, Günter, 78052 Villingen-Schwenningen (DE); Heizmann, Friedrich, 78052 Villingen-Schwenningen (DE); Rekla, Bernd, 78050 Villingen-Schwenningen (DE)
(74) Vertreter: Rossmanith, Manfred, Dr.

(56) Entgegenhaltungen:
- JP-A- 1 136 588
- JP-A- 4 150 792
- US-A- 4 283 664
- US-A- 4 354 145
- US-A- 4 658 190
- US-A- 5 182 500

## Beschreibung

Die Erfindung geht aus von einer Schaltung zur Steuerung mit drei Sensoren gemäß dem Oberbegriff des Anspruchs 1. Eine derartige Schaltung wird z.B. verwendet zur Kommutierung oder Geschwindigkeitsregelung des Capstanmotors in einem Videorecorder. Eine Schaltung gemäß Oberbegriff des Anspruchs 1 ist aus JP-A-04 150 792 bekannt. Die EP-B-0 351 697 Zeigt eine Schaltung zur Steuerung mit zwei Sensoren.

Als Sensoren für die jeweilige Winkelstellung des Rotors können Hallelemente verwendet werden. Der Ausgangsspannung eines derartigen Elementes sind jedoch Störungen überlagert, die unter anderem von den Motorspulen direkt magnetisch aufgesprochen werden. Derartige Störungen können unter Berücksichtigung aller Toleranzen größer als die kleinste Signalspannung sein. Aus diesem Grunde ist eine einfache Lösung, z.B. die Störungen mittels einer Schwellspannung oder Hysterese herauszufiltern, nicht oder nur bedingt einsetzbar. Auch eine AGC-Schaltung ist nicht anwendbar, da der Motor aus dem Stand heraus sofort richtig starten muß. Eine AGC-Schaltung würde einige Schwingungen im Eingangssignal brauchen, um sich zu stabilisieren.

Der Erfindung liegt die Aufgabe zugrunde, eine Schaltung zu realisieren, die auch in der Lage ist, die genannten Störungen zu unterdrücken, und diese Fähigkeit auch zeitlich unbegrenzt aufrechterhält. Bei Anwendung auf einen Motor soll die Schaltung auch bei Motorstillstand Störungen unterdrücken können.

Diese Aufgabe wird durch die im Anspruch 1 angegebene Erfindung gelöst. Vorteilhafte Weiterbildungen der Erfindung sind in den abhängigen Ansprüchen angegeben.

Bei der Erfindung wird also einem Eingang eines Differenzverstärkers bzw. Komparators für die Ausgangsspannungen eines Sensors jeweils die Summe von zwei gegeneinander phasenverschobenen Sensorsignalen getrennter Sensoren zugeführt. Vorzugsweise sind jeweils Ausgänge verschiedener Sensoren direkt miteinander verbunden. Bei der beanspruchten Anordnung von 3 Sensoren ist jeweils ein Ausgang eines Sensors mit einem Ausgang des nächsten Sensors und dann ein Ausgang des letzten Sensors wieder mit dem einem Ausgang des ersten Sensors verbunden, wobei die jeweils miteinander verbundenen Ausgänge der Sensoren unterschiedliche Polarität aufweisen. Es ist nicht unbedingt notwendig, daß zur Erzielung der gewünschten Wirkung die Ausgänge unmittelbar miteinander verbunden, also kurzgeschlossen werden. Es kommt darauf an, daß das jeweils einem Eingang eines Komparators zugeführte Signal aus den Signalen von zwei Ausgängen von zwei getrennten Sensoren zusammengesetzt ist. Die Sensoren sind vorzugsweise als Hallelemente ausgebildet, die auf die Einwirkung eines Magnetfeldes ansprechen. Die Sensoren dienen vorzugsweise zur Detektierung der Winkelstellung des Rotors eines Elektromotors für eine Kommutierung oder Drehzahlregelung, z.B. des Capstanmotors in einem Videorecorder.

Durch die erfindungsgemäße Lösung ergeben sich mehrere Vorteile. Dadurch, daß jeweils zwei Ausgänge getrennter Sensoren zu einem Ausgang zusammengefaßt sind, wird die Gesamtzahl der Ausgänge aller Sensoren halbiert. Wenn somit die Sensoren auf einem IC angeordnet sind, wird dadurch die Anzahl der am IC benötigten Anschlußstifte oder Pins halbiert. Das ist in der Praxis hinsichtlich Herstellung des IC und Raumausnutzung besonders vorteilhaft. Hinsichtlich der Störunterdrückung wird folgende vorteilhafte Wirkung erreicht. Wenn z.B. eine Spule in einem die Sensoren enthaltenden Motor bestromt wird, gibt es ein Übersprechen auf alle, vorzugsweise drei Sensoren. Dabei empfängt ein Sensor das Übersprechen in positiver Richtung und ein anderer Sensor in negativer Richtung. Durch das Zusammenfassen von Ausgangsspannungen unterschiedlicher Phase von getrennten Sensoren, z.B. das Kurzschließen der Ausgänge, werden die Anteile des Übersprechens an den beiden Sensorausgängen nunmehr gemeinsamen Ausgang kompensiert. Beispielsweise bekommt der erste Komparator ein Übersprechen von dem ersten Sensor und ein Übersprechen anderer Phase von dem zweiten Sensor. Auf diese Weise werden durch die vektorielle Addition von Störspannungskomponenten, die vorzugsweise eine Phasenverschiebung von 120° zueinander haben, Übersprechsignale kompensiert. Trotzdem wird erreicht, daß die Signale an den Ausgängen der Komparatoren wieder die richtige Phase relativ zu den Sensorsignalen an den Ausgängen der Sensoren haben.

Die Erfindung wird im folgenden anhand der Zeichnung erläutert. Darin zeigen
- Fig. 1: eine bekannte Auswertschaltung für drei Sensoren,
- Fig. 2: eine erfindungsgemäß ausgebildete Auswertschaltung,
- Fig. 3: eine Tabelle für die in Fig. 2 stehenden Signale,
- Fig.4,5: Kurven zur Erläuterung der Fig. 1 und
- Fig.6-8: Kurven zur Erläuterung der erfindungsgemäßen Schaltung gemäß Fig. 2,
- Fig. 9: eine nicht beanspruchte Schaltung,
- Fig. 10: Kurven zur Erläuterung der Wirkungsweise der Schaltung nach Fig. 9,
- Fig. 11: eine weitere nicht beanspruchte Schaltung,
- Fig. 12: Kurven zur Erläuterung der Wirkungsweise der Schaltung nach Fig. 11,
- Fig. 13: eine Schaltungsvariante der erfindungsgemäßen Schaltung und
- Fig. 14: Kurven zur Erläuterung der Wirkungsweise der Schaltung nach Fig. 13.

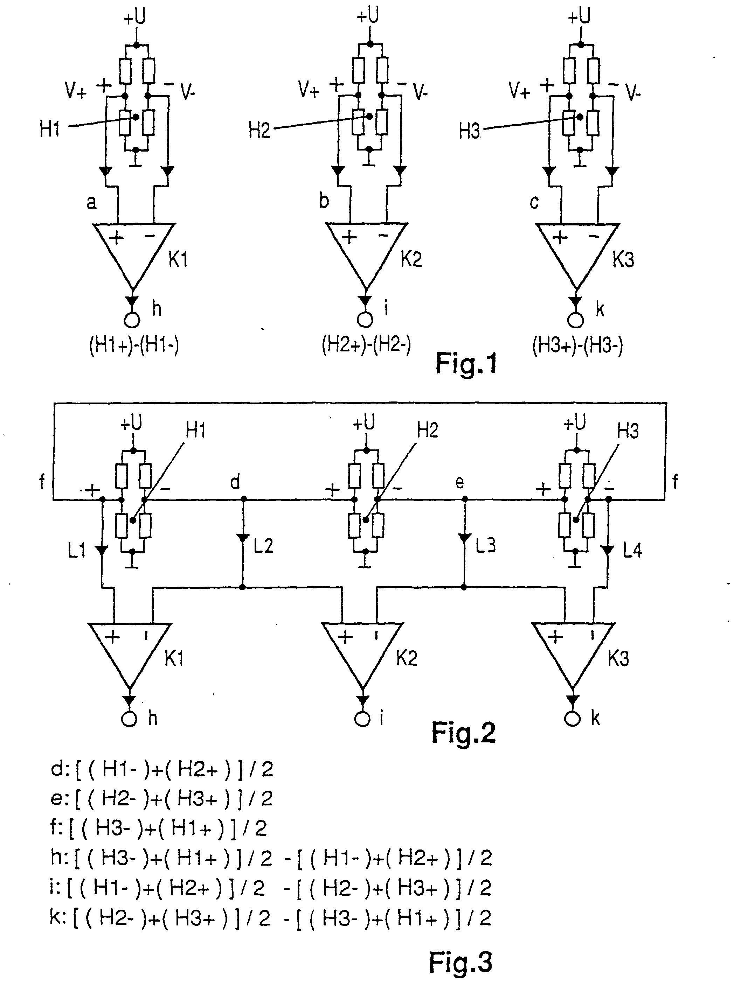

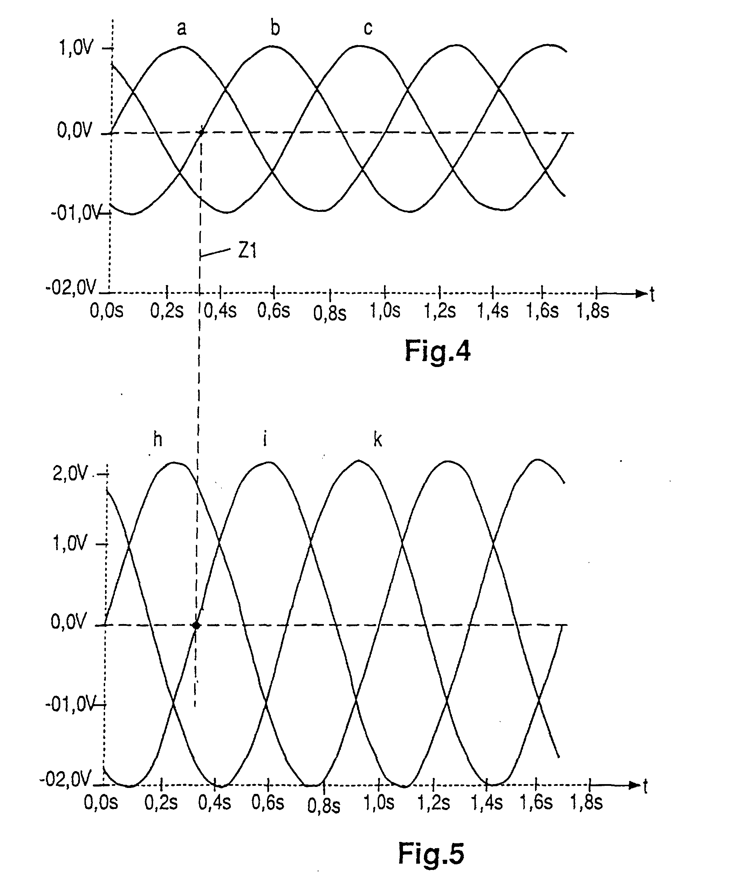

Dabei zeigen die kleinen Buchstaben a-k, an welchen Punkten in Fig. 1, 2 die Signale gemäß Fig. 4-8 stehen. Die in Fig. 3 verwendeten Symbole haben folgende Bedeutung.
- H1+: Sensorsignal am positiven Ausgang des Sensors H1
- H1-: Sensorsignal am negativen Ausgang des Sensors H1
- H2+: Sensorsignal am positiven Ausgang des Sensors H2
- H2-: Sensorsignal am negativen Ausgang des Sensors H2
- H3+: Sensorsignal am positiven Ausgang des Sensors H3
- H3-: Sensorsignal am negativen Ausgang des Sensors H3

Fig. 1 zeigt drei als Hallelemente ausgebildete Sensoren H1, H2, H3, die je in Form von Widerständen in Form einer Brückenschaltung dargestellt sind. Jeder Sensor hat einen positiven Ausgang mit dem Signal V+ und einen negativen Ausgang mit dem Signal V-. Jeweils die Ausgangssignale V+ und V- der Sensoren H1-H3 werden den Eingängen von drei Differenzverstärkern K1, K2, K3 zugeführt, die an ihren Ausgängen h, i, k die dargestellten Signale liefern. In digitalen Anwendungen können die Differenzverstärker K1-K3 durch Komparatoren ersetzt werden.

Fig. 4 zeigt die Signale a, b, c, an den positiven Ausgängen der Sensoren H1, H2, H3, die gleiche Amplitude und gegeneinander eine Phasenverschiebung von 120° aufweisen. Die entsprechenden um 180° gegenphasigen Sensorsignale V- sind in Fig. 4 zur Vereinfachung nicht dargestellt.

Fig. 5 zeigt die sich daraus ergebenden Ausgangssignale h, i, k an den Ausgängen der Komparatoren K1, K2, K3, die wegen der doppelten Negierung die doppelte Amplitude der Signale gemäß Fig. 4 haben. Wie durch die senkrechte gestrichelte Linie Z1 angedeutet, haben die Signale gemäß Fig. 4, 5 gleiche Phase. Diese Schaltung kann keine Störungen unterdrücken, die durch magnetisches Übersprechen von Spulen eines Motors auf die Sensoren gelangen.

In Fig. 2 sind die Ausgänge der Sensoren H1, H2, H3 durch die dargestellten Leitungen miteinander verbunden, also kurzgeschlossen. Die gesamte Anordnung der Sensoren hat dann nur noch drei Ausgänge d, e, f, die über die Leitungen L1, L2, L3, L4 auf die entsprechenden Eingänge der Komparatoren K1, K2, K3 geführt sind, wobei die Leitungen L1 und L4 dasselbe Signal führen.

Fig. 3 zeigt die in Fig. 2 sich ergebenden Signale. Da die Ausgänge der Sensoren H1, H2, H3 gleiche Ausgangswiderstände aufweisen, das Sensorsignal eines Sensors also durch den Ausgangswiderstand dieses Sensors und den Ausgangswiderstand des damit verbundenen Sensors halbiert wird, ergibt sich jeweils am dem Ausgang die Hälfte der Summe der Sensorsignale von den beiden miteinander verbundenen Sensoren. Es ist ersichtlich, daß jedes Signal an den Eingängen der Komparatoren K1-K3 aus zwei Sensor-Ausgangssignalen zusammengesetzt ist. Ebenso ist ersichtlich, daß die Ausgangssignale h, i, k an den Ausgängen der Differenzverstärker K1-K3 immer aus Signalanteilen aller drei Sensoren H1, H2, H3 zusammengesetzt sind. Dabei sind die Vorzeichen so, daß Störungen von den drei Sensoren H1, H2, H3 an den Komparatoren einander aufheben, ohne daß dabei die Nutzsignale beeinträchtigt werden.

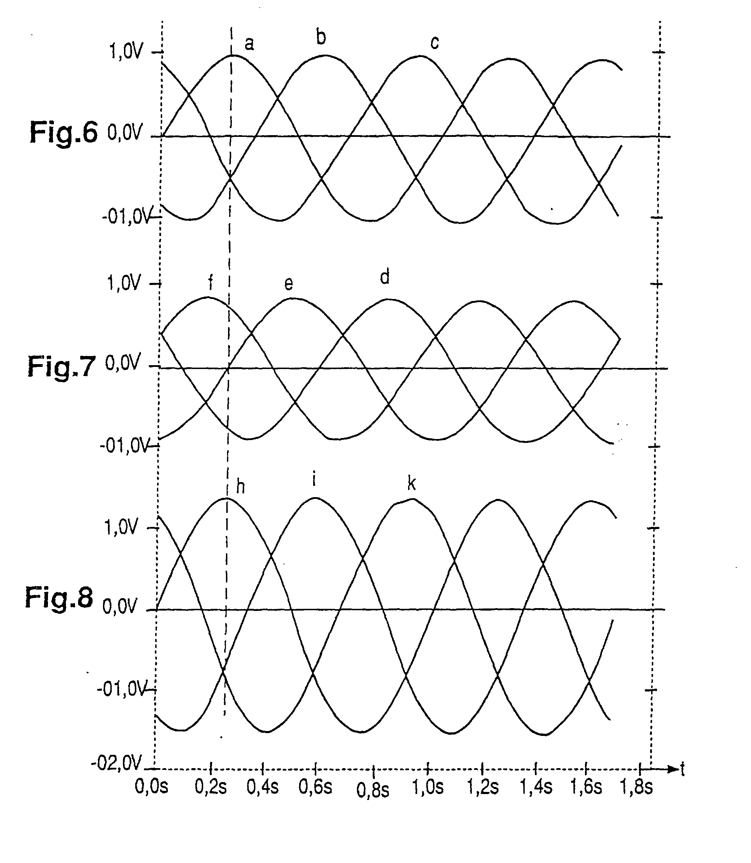

Fig. 6 zeigt noch einmal die Signale a, b, c gemäß Fig. 4. Fig. 7 zeigt die sich daraus ergebenden Signale e, f, d gemäß Fig. 2. Es ist ersichtlich, daß durch vektorielle Addition von Sensorsignalen getrennter Sensoren eine Phasenverschiebung zwischen den Signalen gemäß Fig. 6 und dem Signal gemäß Fig. 7 auftritt. Die Nulldurchgänge der Signale sind also gegeneinander verschoben, wie ein Vergleich der Fig. 6, 7 zeigt.

Fig. 8 zeigt die Ausgangssignal i, h, k an den Ausgängen der Differenzverstärker K1, K2, K3. Die Amplitude dieser Signale ist dabei ohne Bedeutung, da nur die Nulldurchgänge ausgewertet werden. Es ist ersichtlich, daß die Nulldurchgänge der Signale in Fig. 8 relativ zu den Signalen in Fig. 6 wieder die richtige Lage haben. An jedem Ausgang der Differenzverstärker wird also bei der Detektierung der Nulldurchgänge trotz der Kombination der Sensorsignale nur das Sensorsignal des dem Komparator zugeordneten Sensors ausgewertet.

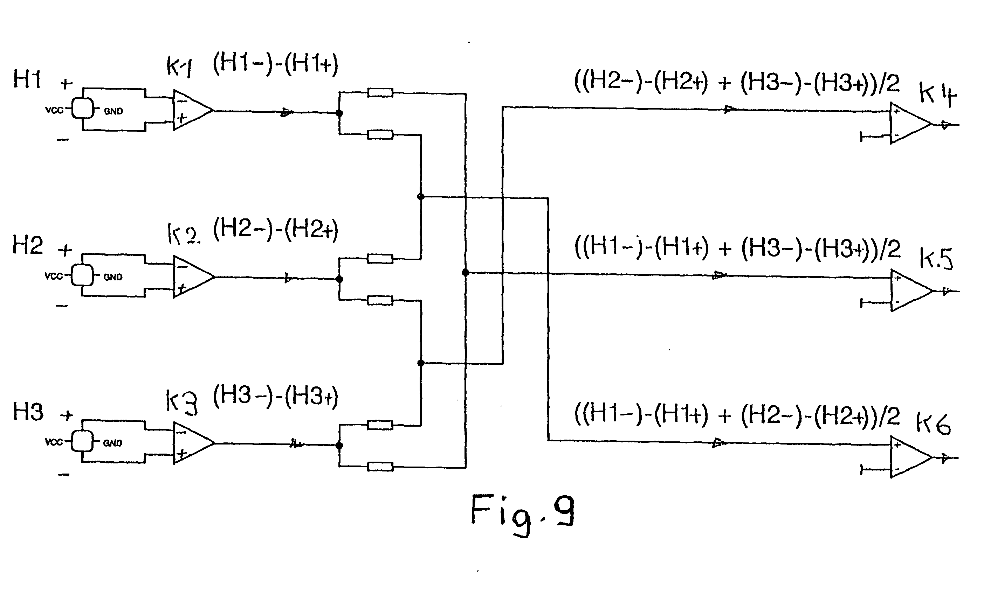

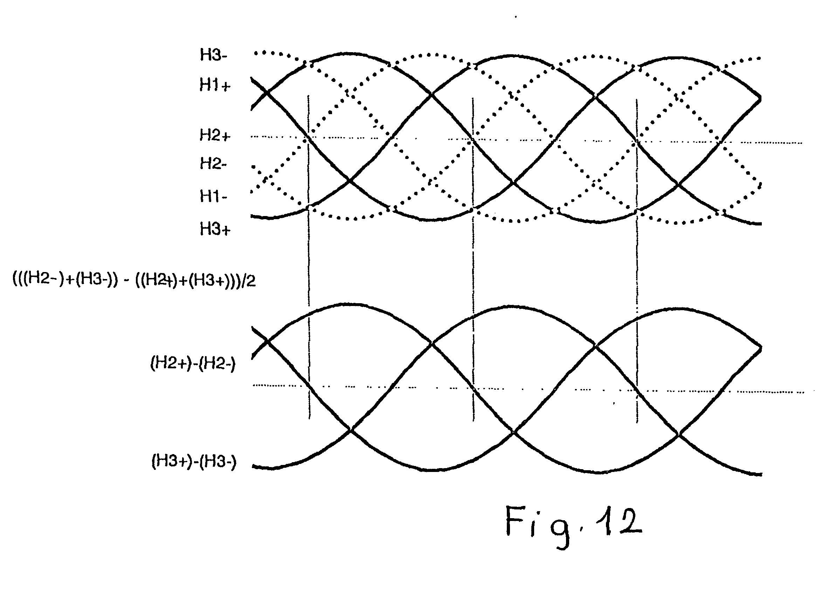

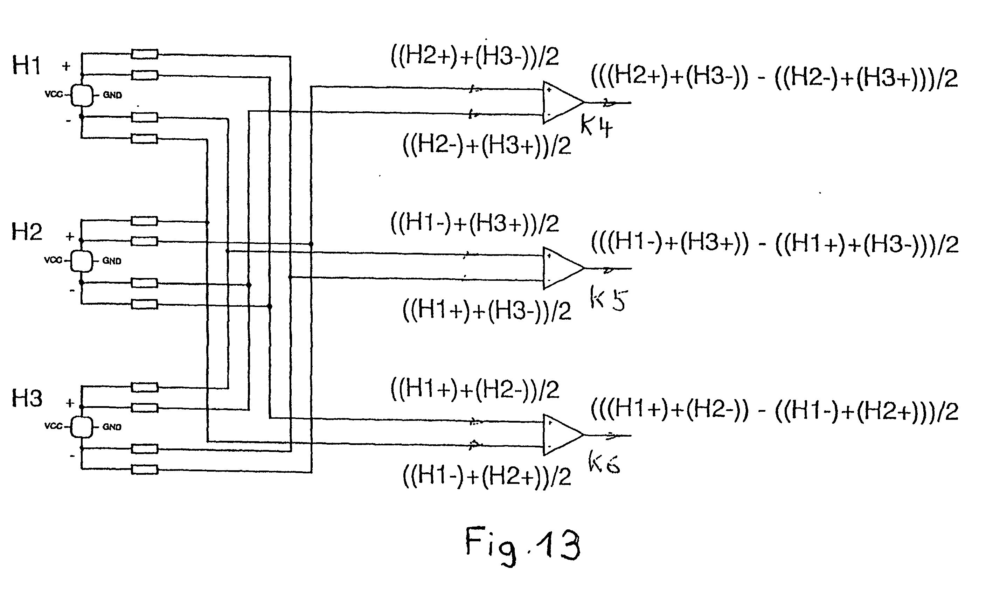

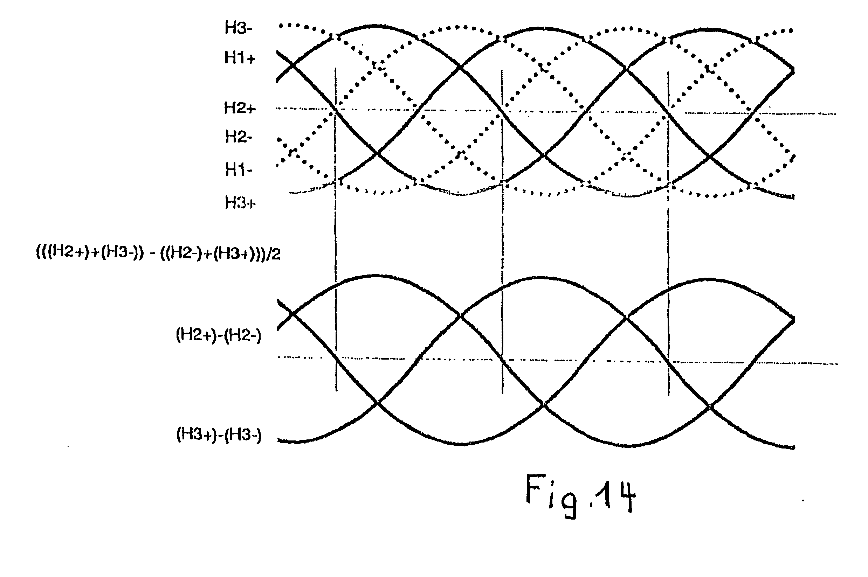

Wenn die Signale der Sensoren H1, H2, H3 unterschiedliche Amplituden oder unterschiedliche Innenwiderstände aufweisen, kann es zu Verzerrungen in den erzeugten Ausgangssignalen kommen, insbesondere dann, wenn die Hallelemente einen sogenannten Offset aufweisen. Anhand der Figuren 9 bis 14 werden Varianten beschrieben, die insbesondere derartige Abweichungen aufgrund eines Offsets vermeiden.

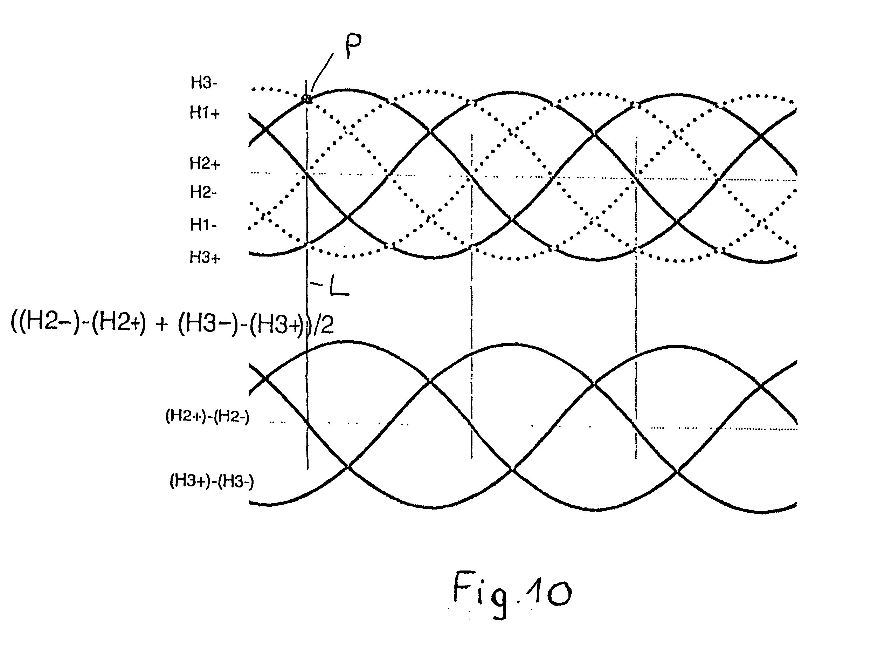

Die grundsätzliche Wirkungsweise der genannten Weiterbildung wird zunächst anhand der Fig. 10 beschrieben. Der obere Teil von Fig. 10 zeigt wieder die Signale der Sensoren H1, H2, H3, und zwar für beide Polaritäten. Die ausgezogene Linie zeigt jeweils das positive und die punktierte Linie das negative Signal, die jeweils bei einem Sensor um 180° verschoben sind. Jeweils die Addition z.B. von H3- und H3+ ergibt wieder einen Sinus mit denselben Nulldurchgängen. Ausgewertert wird jeweils nur der Nulldurchgang eines Signals, z.B. für das Einschalten der nächsten Spule bei einem Motor. Deshalb spielt die Amplitude der Signale für die Auswertung keine Rolle. Es sei jetzt der erste Nulldruchgang des Signals H1+ betrachtet, der durch die Linie L markiert ist. Es ist ersichtlich, daß bei diesem Nulldurchgang die Signale H3- und H2+ den Schnittpunkt P aufweisen, also gleiche Amplituden haben. Der erste Nulldurchgang von H1+ läßt sich somit auch aus dem Kriterium ableiten, daß die Signale H2+ und H3- der beiden anderen Sensoren gleiche Amplitude aufweisen. Das bedeutet, daß für die Erzeugung des eigentlichen Ausgangssignals eines Sensors das Signal dieses Sensors gar nicht benötigt wird, sondern durch die Signale von zwei anderen Sensoren ersetzt werden kann. Es ist dann möglich, für einen Sensor eine Auswertung des Nulldurchgangs zu bewirken, ohne daß dafür das Signal des Sensors selbst herangezogen werden muß. Stattdessen werden die Signale von zwei anderen Sensoren verwendet. Diese haben jedoch während des genannten Nulldurchgangs des ersten Sensors eine nennenswerte Amplitude.

Die in den Figuren 9, 11, 13 dargestellten und durch Gleichungen ergänzten Schaltungen sind nunmehr so aufgebaut, daß jeweils das Ausgangssignal eines Sensors nur aus Ausgangssignalen jeweils der anderen Sensoren zusammengesetzt ist, also das eigentliche Ausgangssignal des eigenes Sensors gar nicht mehr enthält. Die dargestellten Differenzverstärker K4, K5, K6, die den Sensoren H1, H2, H3 zugeordnet sind, erhalten also jeweils nur Signale der anderen Sensoren. Fig. 9 zeigt, daß der Differenzverstärker K4, der das Ausgangssingal des Sensors H1 liefert, nur Signalanteile der Sensoren H2 und H3 bekommt. Ebenso erhält der Komparator K5 für den Sensor H2 nur Signalanteile der Sensoren H1 und H3 und der Komparator K6 für den Sensor H3 nur Signalanteile der Sensoren H1 und H2.

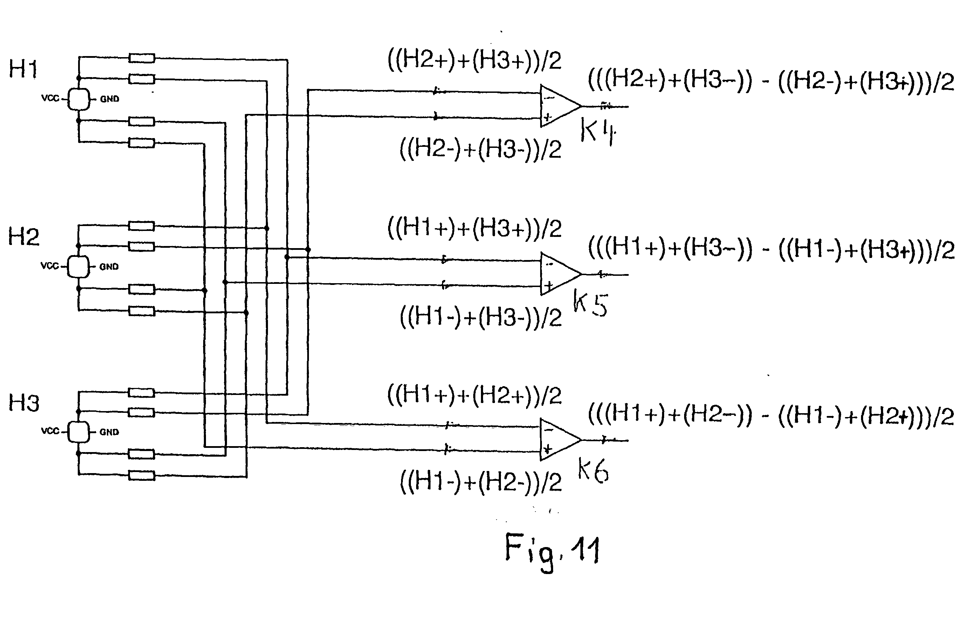

Fig. 10 zeigt, daß ebenso die Summe der Signale H2+ und H3+ im Nulldurchgang von H1+ null ergibt und daher ebenfalls ausgewertet werden kann. Diese Variante ist in Fig. 11 dargestellt. Ebenso ist es möglich, die Signale H2- und H3- zu addieren. Diese Summe ergibt ebenfalls in Fig. 10 den Wert null beim Nulldurchgang von H1+.

Die beschriebene Weiterbildung der Erfindung hat folgenden Vorteil. Die Sensoren, insbesondere die Hallelemente, können einen Offset aufweisen. Dieser Offset ist bei dem "+"-Ausgang und dem "-"-Ausgang gleich groß. Wie insbesondere Fig.9 und Fig. 11 zeigen, enthalten den Gleichungen an den Ausgängen der Differenzverstärker K4, K5, K6 jeweils Signalanteile der anderen Sensoren entgegengesetzter Polaritäten, also am Ausgang von K4 z.B. H2+ und H2- und H3+ und H3-. Da der Offset an den "+"-Ausgängen und "-"-Ausgängen immer gleich groß ist, kommt es dadurch in vorteilhafter Weise zu einer Kompensation des an sich störenden Offset.

## Patentansprüche

1. Schaltung zur Steuerung mit drei Sensoren (H1, H2, H3), die je einen positiven (+) und einen negativen (-) Signalausgang aufweisen für die Erzeugung einander entgegengesetzter gleichartiger Sensorsignale (V+, V-), die zur Auswertung den jeweils zwei Signaleingängen von drei Differenzverstärkern (K1, K2, K3) zugeführt werden, **dadurch gekennzeichnet, dass** jeder Signaleingang eines Differenzverstärkers (K1-K3; K4-K6) mit je einem der Signalausgänge von jeweils zwei Sensoren (H1, H2, H3) verbunden ist, so dass jeder Signaleingang mit einer Kombination aus zwei Sensorsignalen unterschiedlicher Sensoren gespeist wird, wobei die jeweiligen zwei, mit einem Signaleingang eines Differenzverstärkers (K1-K3; K4-K6) verbundenen Signalausgänge (+, -) der Sensoren (H1, H2, H3) unterschiedliche Polarität aufweisen.

2. Schaltung nach Anspruch 1, **dadurch gekennzeichnet, dass** die Sensoren (H1, H2, H3) als Hallelemente ausgebildet sind.

3. Schaltung nach Anspruch 1 und/oder 2, **dadurch gekennzeichnet, dass** die Sensoren (H1, H2, H3) zur Detektierung der Winkelstellung des Rotors eines elektronisch kommutierbaren Elektromotors bei dessen Kommutierung und/oder Drehzahlregulierung vorgesehen sind.

4. Schaltung nach Anspruch 1, **dadurch gekennzeichnet, dass** in digitalen Anwendungen Komparatoren anstelle von Differenzverstärkern (K1-K3; K4-K6) verwendet werden.

## Claims

1. Control circuit having three sensors (H1, H2, H3) each containing a positive(+) and a negative (-) signal output for producing mutually opposed sensor signals (V+, V-) of the same kind which are fed for evaluation to the respective two signal inputs of three differential amplifiers (K1, K2, K3),
**characterized in that**
each signal input of a differential amplifier (K1-K3; K4-K6) is connected with respectively one of the signal outputs of respectively two sensors (H1, H2, H3) so that each signal input is fed by a combination of two sensor signals of different sensors, wherein respective two signal outputs (+, -) connected to the signal input of a differential amplifier (K1-K3; K4-K6) of the sensors (H1, H2, H3) exhibit different polarities.

2. Circuit according to claim 1, **characterized in that** the sensors (H1, H2, H3) are configured in form of Hall elements.

3. Circuit according to claim 1 and/or 2, **characterized in that** the sensors (H1, H2, H3) are provided for detecting the angular position of the rotor of an electronically commutated electro motor at its commutation and/or speed regulation.

4. Circuit according to claim 1, **characterized in that** with digital applications comparators are employed instead of differential amplifiers (K1-K3; K4-K6).

## Revendications

1. Circuit de commande à trois capteurs (H1, H2, H3) qui présentent chacun des signaux de capteur déphasés équivalents (V+, V-), acheminés respectivement à deux entrées de signaux de trois amplificateurs différenciateurs (K1, K2, K3) pour évaluation, chaque entrée de signal d'un amplificateur différenciateur (K1-K3 ; K4-K6) étant reliée à une des sorties de signaux de deux capteurs (H1, H2, H3) de sorte que chaque entrée de signal soit alimentée par une combinaison de deux signaux de capteur de capteurs différents, **caractérisé en ce que** les deux sorties respectives de signaux (+, -) des capteurs (H1, H2, H3), reliées à une entrée de signal d'un amplificateur différenciateur (K1-K3 ; K4-K6), présentent une polarité différente.

2. Circuit selon la revendication 1, **caractérisé en ce que** les capteurs (H1, H2, H3) sont des éléments à effet Hall.

3. Circuit selon la revendication 1 et/ou 2, **caractérisé en ce que** les capteurs (H1, H2, H3) sont prévus pour détecter l'angle de conicité du rotor d'un moteur électrique commutable électroniquement lors de sa commutation et/ou du réglage de sa vitesse.

4. Circuit selon la revendication 1, **caractérisé en ce que** des comparateurs sont utilisés dans des applications numériques à la placé d'amplificateurs différenciateurs (K1-K3 ; K4-K6).
